# EUROPÄISCHE PATENTSCHRIFT

(11) **EP 1 494 336 B1**
(45) Veröffentlichungstag und Bekanntmachung des Hinweises auf die Patenterteilung: **20.01.2010**
(21) Anmeldenummer: 04005092.4
(22) Anmeldetag: 04.03.2004
(51) Int. Cl.: H02K 11/04, H01L 25/11

(54) **Gleichrichtereinrichtung, insbesondere für einen Drehstromgenerator**
Rectifier, in particular suitable for an alternating current generator
Redresseur, en particulier approprié à un alternateur

(30) Priorität: 30.06.2003 DE 10329571
(43) Veröffentlichungstag der Anmeldung: 05.01.2005
(73) Patentinhaber: ROBERT BOSCH GMBH, 70442 Stuttgart (DE)
(72) Erfinder: Winter, Falko A., 71636 Ludwigsburg (DE)

(56) Entgegenhaltungen:
- EP-A- 0 428 301
- US-A- 4 799 309
- US-A- 5 883 450
- US-A- 6 150 196

## Beschreibung

### Stand der Technik

Aus dem Stand der Technik sind Gleichrichtereinrichtungen bekannt, die zwei Kühlkörper aufweisen, einen Minuskühlkörper und einen Pluskühlkörper, und zwischen sich eine sogenannte Verschaltungsplatte aufnehmen, die dazu bestimmt ist, die Dioden untereinander so zu verschalten, dass die für Drehstromgeneratoren üblichen Brückenschaltungen erzeugt werden. Die bekannten Gleichrichtereinrichtungen sind bis auf wenige Kontaktstellen oder überhaupt nicht beschichtet. Zu diesen Kontaktstellen gehören beispielsweise der sogenannte B+ Bolzen-Anschluss sowie die üblicherweise drei bis sechs Ständeranschlussfahnen, die unbeschichtet bleiben müssen, damit eine sichere, zuverlässige elektrische Verbindung zwischen Ständerdrähten und Anschlussfahnen herstellbar ist. Am sogenannten B+ Bolzenanschluss ist ein Kabelschuh zu befestigen, der eine Ladeleitung mit der Batterie eines Kraftfahrzeuges verbindet.

Bei vollständig beschichteten Gleichrichtern ist nachteilig, dass diese Beschichtung die von den Kühlkörpern abzugebende Wärme schlecht weiterleitet und somit der Kühleffekt verschlechtert ist. Des weiteren sind zwar alle elektrische Leiter durch diese Beschichtung geschützt; um jedoch die Auswirkungen von Elektrolyten zwischen elektrischen Potentialunterschieden am Gleichrichter zu verringern, ist es nicht erforderlich, sämtliche elektrisches Potential führende Leiter zu beschichten. Bei gar nicht beschichteten Gleichrichtern ist zwar die Wärmeabgabe sehr gut, dagegen sind diese gegenüber Elektrolyten besonders anfällig.

Aus dem Dokument US 5,883,450 A1 ist eine Gleichrichterbaueinheit für einen Drehstromgenerator mit einem ersten nicht isolierten Leiter mit positivem Potential, benachbart befindet sich dazu ein zweiter Leiter zu den Enden der Statorwicklungen. Der zweite Leiter ist mit einer Isolation beschichtet.

Aus dem Dokument US 6,150,196 A1 ist ein Verfahren zum Herstellen einer Gleichrichterbaueinheit bekannt, wonach an Kühlkörpern Dioden befestigt und deren Anschlussleiter mit dem Verbindungsleiter verbunden werden Anschließend wird die so gebildete Gleichrichterbaueinheit einschließlich der Anschluss- und Verbindungsleiter mit Isolierung beschichtet.

Vorteile der Erfindung

Die erfindungsgemäße Gleichrichterbaueinrichtung mit den Merkmalen des Anspruchs 1 hat den Vorteil, dass einerseits ein guter Wärmeübergang zwischen den Leitern und der Umgebungsluft ermöglicht ist und andererseits ein ausreichender Korrosionsschutz für die elektrischen Bauteile der Gleichrichtereinrichtung vorhanden ist. Zu dem wird weniger Beschichtungsmaterial benötigt und die Trockenzeit verkürzt.

Durch die in den Unteransprüchen aufgeführten Maßnahmen sind vorteilhafte Anspruch 1 Weiterbildungen der Gleichrichterbaueinrichtung nach dem möglich. Durch die vorgesehenen Maßnahmen ist gesichert, dass immer zwischen zwei Potentialdifferenzen zweier Leiter eine Isolationsschicht auf einem Leiter befestigt ist, die somit den Widerstand der Gleichrichterbaueinrichtung gegen elektrochemische Korrosion verbessert. Besonders wichtig ist dieser Schutz zwischen besonders großen Potentialdifferenzen, also zwischen den beiden Kühlkörpern, aber ganz besonders zwischen eng benachbarten elektrisch leitenden Teilen, wie zum Beispiel Diodenkopfdrähten von Plusdioden, die sich in der räumlichen Nähe der Minuskühlkörper bzw. des Minuskühlkörpers befinden. Des weiteren wirken Spannungsdifferenzen zwischen den Diodenkopfdrähten einer Diode und deren entsprechendem Kühlkörper. Des weiteren ist es von Bedeutung, das Anschlussteil für einen Ständeranschlussdraht gegenüber anderen Leitern mit anderen Potentialen isolierend zu trennen.
Anspruch 5 ist ein erfindungsgemäßes Herstellungs verfahren.

### Zeichnungen

In den Zeichnungen sind Ausführungsbeispiele einer Gleichrichterbaueinrichtung sowie ein Verfahren zur Herstellung einer Gleichrichterbaueinrichtung dargestellt. Es zeigen:
- Figur 1: eine prinzipielle Darstellung einer Gleichrichterbaueinrichtung mit zwei Kühlkörpern, in die Gleichrichterdioden eingepresst sind, sowie eine Verschaltungsplatte,
- Figur 2: bis
- Figur 7: verschiedene Detailansichten zweier sich gegenüberstehender Leiter,
- Figur 8: eine räumliche Teilansicht eines Teils einer Gleichrichterbaueinrichtung,
- Figur 9: eine Gleichrichterteilbaugruppe vor dem Zusammenfügen mit einem zweiten Kühlkörper,
- Figur 10: verschiedene Verfahrensschritte zur Herstellung der Gleichrichterbaueinrichtung aus Figur 9.

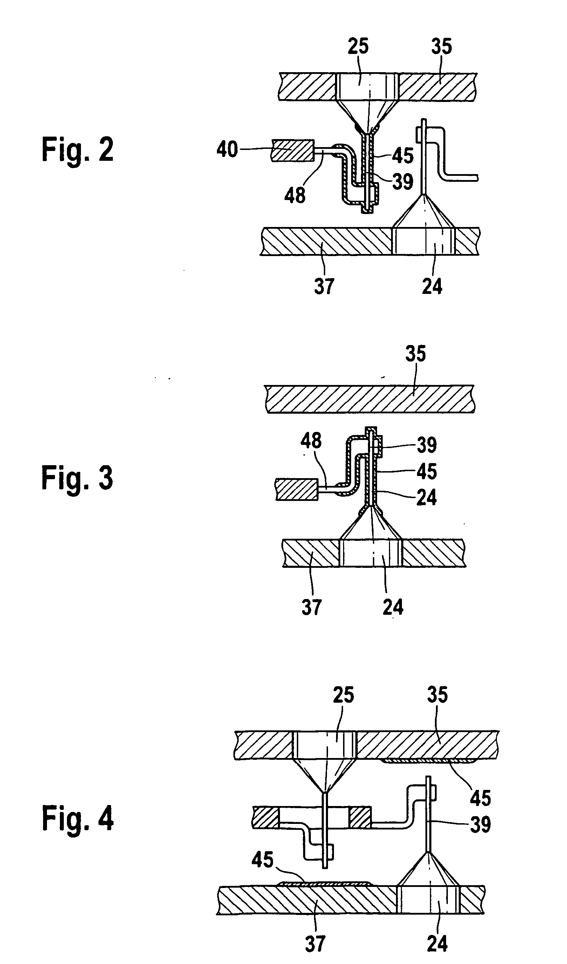

### Die Figuren 2 und 3, sowie die Figuren 5 bis 10 und die dazugehörige Beschreibung sind nicht Teil der beanspruchten Erfindung.

### Beschreibung

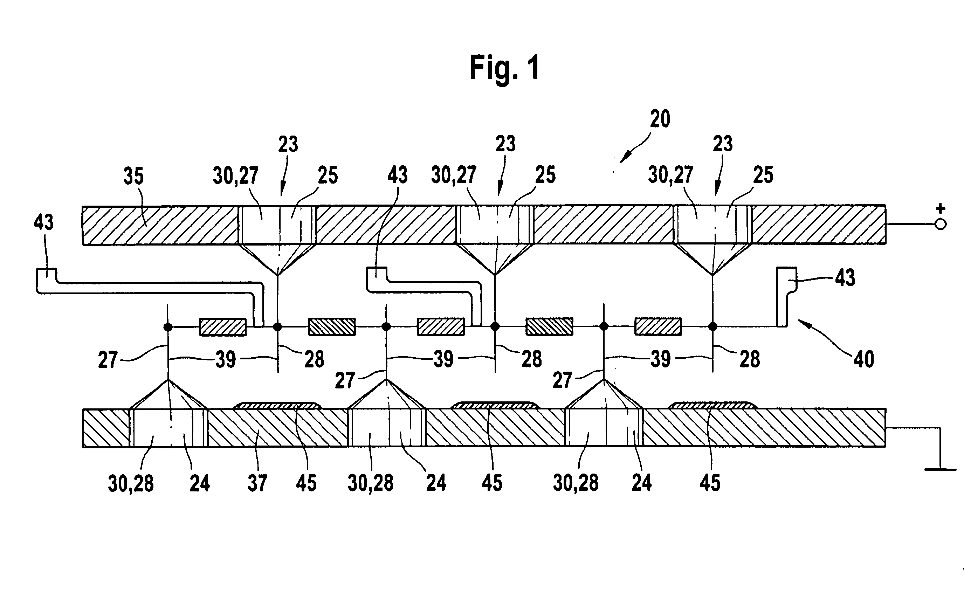

In Figur 1 ist schematisch eine Gleichrichterbaueinrichtung 20 dargestellt, die insgesamt drei Gleichrichterbrücken 23 zeigt. Die drei Gleichrichterbrücken weisen je eine Minusdiode 24 und je eine Plusdiode 25 auf. Jede der Dioden 24 bzw. 25 hat je eine positive Seite 27 bzw. eine negative Seite 28. Bei den Plusdioden 25 und den Minusdioden 24 sind im Ausführungsbeispiel je ein Diodensockel 30 vorhanden. Bei den Minusdioden 24 sind die Diodensockel 30 die negative Seite 28 der Minusdiode 24, bei den Plusdioden 25 sind die Diodensockel 30 die positive Seite 27 der Dioden. Die Plus- und Minusdioden 25 bzw. 24 stecken mit ihrem jeweiligen Diodensockel 30 in je einer Öffnung eines Pluskühlkörpers 35 bzw. eines Minuskühlkörpers 37. Der Minuskühlkörper ist, wie dargestellt, mit der elektrischen Masse des hier nicht in Gänze dargestellten Drehstromgenerators, für den diese Gleichrichterbaueinrichtung vorgesehen ist, verbunden. Der Pluskühlkörper ist, wie üblich, mittels eines Plusanschlusses mit einer hier nicht dargestellten Ladeleitung einer ebenso nicht dargestellten Fahrzeugbatterie verbunden.

In der in Figur 1 dargestellten Gleichrichterbaueinrichtung 20 zeigen die sogenannten Diodenkopfdrähte 39 der einen Diode jeweils auf den Kühlkörper der gegenüberliegenden anders gepolten Diode. Auch diese Diodenkopfdrähte 39 bilden je nach Art der Diode jeweils eine positive Seite 27 bzw. eine negative Seite 28 der jeweiligen Diode derart, dass die Diodenkopfdrähte 39 der Minusdioden 24 positive Seiten 27 sind, während die Diodenkopfdrähte der Plusdioden 25 negative Seiten 28 sind. Die Diodenkopfdrähte 39 jeweils zweier Dioden einer Gleichrichterbrücke 23 sind mittels einer in Figur 1 schematisch dargestellten Verschaltungsplatte 40 elektrisch leitend verbunden. Jede Gleichrichterbrücke 23 wird über je ein Anschlussteil 43 mit je einem Phasenausgang einer Phasenwicklung der hier nicht dargestellten Ständerwicklung des Drehstromgenerators verbunden. Die Verschaltungsplatte 40 weist im übrigen zwischen je zwei Gleichrichterbrücken 23 in seinem Isolierteil eine Unterbrechung auf, so dass die Gleichrichterbrücken nur über die Diodensockel 30 miteinander elektrisch verbunden sind. Wie in Figur 1 deutlich zu erkennen ist, ragen die Diodenkopfdrähte 39 der Plusdioden 25 in Richtung zum Minuskühlkörper 37 und enden kurz vor dessen Oberfläche. Eingangs wurde erwähnt, dass bei Gleichrichterbaueinrichtungen das Problem besteht, dass sich durch Verschmutzung oder Feuchtigkeit leicht elektrisch leitfähige Verbindungen zwischen zwei verschiedenen Spannungspotentialen ausbilden. Die Abstände zwischen den zwei verschiedene Potentiale führenden elektrischen Leitern sollen jedoch nicht vergrößert werden, um die Baugröße der Gleichrichterbaueinrichtung nicht zu vergrößern. Als Lösung wird hier vorgeschlagen, dass nur einer der beiden Potential führenden Leiter mit einer Isolation beschichtet ist. Im Beispiel nach Figur 1 ist der Minuskühlkörper 37 an den Stellen mit einer Isolation 45 beschichtet, die den anderen, ein höheres Potential führenden Leitern gegenüberliegend bzw. benachbart sind. In Figur 1 ist demzufolge eine Gleichrichterbaueinrichtung 20 dargestellt und beschrieben, die einen ersten elektrischen Leiter, hier die negative Seite 28 der Plusdioden 25 in Form der Diodenkopfdrähte 39 zum Führen eines ersten Spannungspotentials aufweist und einen zweiten elektrischen Leiter, hier ausgeführt als Minuskühlkörper 37 zum Führen eines zweiten niedrigeren Spannungspotentials, wobei der erste Leiter und der zweite Leiter benachbart sind und nur einer der beiden Leiter, hier der Minuskühlkörper 37, mit einer Isolationsschicht 45 beschichtet ist.

Der zweite Leiter ist als Minuskühlkörper 37 mit einer negativen Seite 28 der Minusdioden 24 verbunden. Dieser als Minuskühlkörper 37 ausgebildete zweite Leiter ist lokal an Stellen beschichtet, die den ersten Leitern, hier in Form der Diodenkopfdrähte 39 der Plusdioden 25, gegenüberstehen. Der erste Leiter in Form des Diodenkopfdrahts 39 ist mit den negativen Seiten 28 der Plusdioden 25 verbunden.

Figur 2 zeigt ausschnittsweise ein weiteres Ausführungsbeispiel der Isolation zwischen zwei verschiedenen Leitern. Wie im Ausführungsbeispiel nach Figur 1 stehen sich auch hier ein Minuskühlkörper 37 und ein Diodenkopfdraht 39 einer Plusdiode 25 derart gegenüber, dass die beiden benachbart sind. Der erste Leiter "Pluskühlkörper 35" ist mit der positiven Seite 27 der Plusdiode 25 verbunden. In diesem Ausführungsbeispiel ist der Diodenkopfdraht 39 der Plusdiode 25 in einem Fall erster Leiter und im anderen Fall zweiter Leiter. Im ersten Fall stellt der Diodenkopfdraht 39 der Plusdiode 25 einen zweiten Leiter dar, der ebenfalls mittels einer Isolation beschichtet ist. Diese Isolationsschicht 45 wirkt gegenüber dem ersten Leiter, ausgeführt als Pluskühlkörper 35. Die Isolationsschicht 45 wirkt aber auch bei der Betrachtung des Diodenkopfdrahts 39 hinsichtlich seiner Lage gegenüber dem Minuskühlkörper 37 als Isolationsschicht 45 auf dem ersten Leiter "Diodenkopfdraht 39" gegenüber dem zweiten Leiter "Minuskühlkörper 37".

Des weiteren ist die Isolationsschicht 45 auch auf einem Verbindungsdraht 48 befindlich, der Teil der Verschaltungsplatte 40 ist. Gegenüber dem Pluskühlkörper 35 ist der Verbindungsdraht 48 ein zweiter Leiter und gegenüber dem Minuskühlkörper 27 ist der Verbindungsdraht 48 ein erster Leiter.

In Figur 3 ist die Isolationsschicht 45 auf einem Diodenkopfdraht 39 einer Minusdiode 24 aufgebracht, so dass sowohl der Verbindungsdraht 48 als auch der Diodenkopfdraht 39 gegenüber dem Minuskühlkörper 37 als erster Leiter wirken und gegenüber dem Pluskühlkörper 35 als zweiter Leiter. Auch hier ist die Beschichtung 45 lokal an einer Stelle aufgebracht, die einem ersten Leiter bzw. einem zweiten Leiter gegenübersteht.

Figur 4 zeigt zusätzlich zu der bereits aus Figur 1 bekannten Art und Weise der Anordnung der Isolationsschicht 45 zusätzlich eine Isolationsschicht 45 auf der Seite des Pluskühlkörpers 35, die dem Diodenkopfdraht 39 einer Minusdiode 24 gegenüber angeordnet ist.

Für den Fall, dass die Diodenkopfdrähte 39 einer Plus- oder Minusdiode 24 bzw. 25 in eine Öffnung 50 eines gegenüberliegenden Kühlkörpers hineinragen, kann der den Diodenkopfdrähten 39 benachbarte Leiter den Diodenkopfdraht 39 ringsum umgeben. In diesem Fall ist es erforderlich, dass sowohl die Oberfläche der Öffnung, d.h. hier im Beispiel die in etwa zylindrische Oberfläche der Öffnung 50, als auch ringförmige Zonen rund um die Öffnung 50 von der Isolationsschicht 45 belegt sind. Im Beispiel ist die Diode eine Plusdiode und der Kühlkörper ein Minuskühlkörper 37.

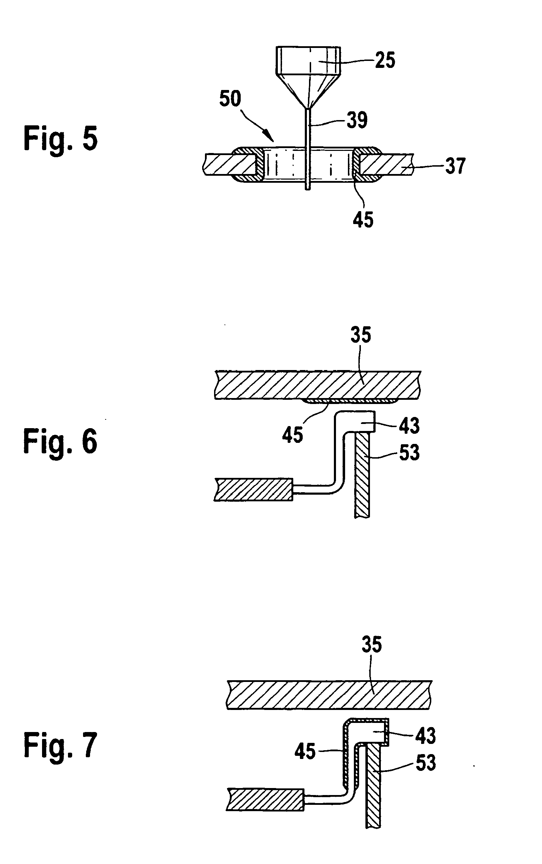

In Figur 6 ist ausschnittsweise die Anordnung eines Anschlussteils 43 gegenüber einem Pluskühlkörper 35 dargestellt. In diesem Fall ist auch hier wiederum eine lokale Beschichtung am Pluskühlkörper 35 gewählt worden, so dass eine freie Weglänge zwischen dem Anschlussteil 43 zu einem unisolierten Bereich des Pluskühlkörpers 35 deutlich verlängert ist.

Figur 7 zeigt alternativ die Beschichtung des Anschlussteils 43 bzw. eines Ständeranschlussdrahts 53 gegenüber einem Pluskühlkörper 35.

Die Ausführungsbeispiele in Figur 6 und Figur 7 sind nicht, auf Anordnungen gegenüber den Pluskühlkörpern 35 beschränkt, sondern gelten auch für die Minuskühlkörper 37.

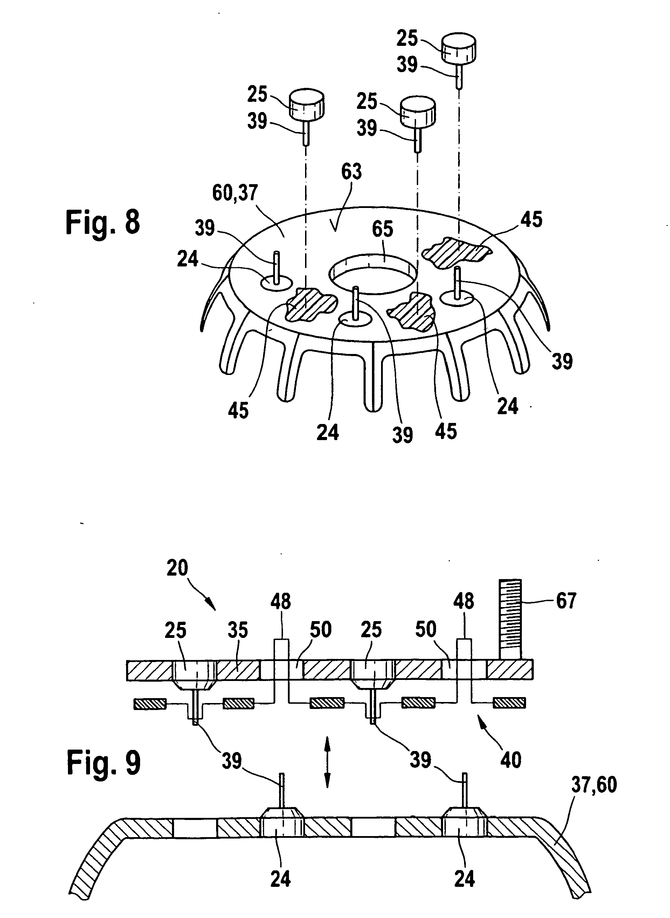

In Figur 8 ist stark schematisch dargestellt, wie eine Anordnung von Isolationsschichten 45 auf Kühlkörpern ausgeführt sein kann. Im Beispiel ist ein Minuskühlkörper 37 dargestellt, der hier als Lagerschild 60 ausgeführt ist. Dieses Lagerschild 60 weist eine in etwa ringförmige Stirnfläche 63 auf, die nach radial innen in einer Nabe 65 endet. Diese Nabe 65 ist dazu vorgesehen, ein Lager zur Stützung eines nicht dargestellten Läufers aufzunehmen. Es ist hierbei vorgesehen, dass die Stirnfläche 63 in Umfangsrichtung mehrere Öffnungen aufweist, in die in diesem Fall Minusdioden 24 eingesetzt sind. Zur platzsparenden Anordnung zwischen diesen Minusdioden 24 bzw. zwischen deren Diodenkopfdrähten 39 ist vorgesehen, dass Plusdioden 25 bzw. deren Diodenkopfdrähte 39 zwischen den Minusdioden 24 angeordnet sind. Zur Beseitigung der Überbrückungsgefahr zwischen den unterschiedliche Spannungen führenden Teilen ist vorgesehen, siehe auch Ausführungsbeispiel gemäß Figur 1, dass zwischen den Minusdioden 24 an lokalen Stellen eine Isolationsschicht 45 aufgebracht ist. Wie symbolisch dargestellt, ist vorgesehen, dass die Diodenkopfdrähte 39 der Plusdioden 25 auf diese Isolationsschichten 45 gerichtet sind.

Figur 9 zeigt ein weiteres Ausführungsbeispiet für eine Gleichrichterbaueinrichtung 20. In den Pluskühlkörper 35 sind Plusdioden 25 und ein sogenannter B+ Anschluss 67 in Form eines Schraubenbolzens eingesetzt. Nach dem Einsetzen der Plusdioden 25 wird die Verschaltungsplatte 40 mit den Diodenkopfdrähten 39 der Plusdioden 25 elektrisch leitfähig und mechanisch verbunden, so dass eine Gleichrichterteilbaugruppe gebildet ist.

Diese Gleichrichterteilbaugruppe wird nun so mit der Isolationsschicht 45 beschichtet, dass die Anschlussleiter, gebildet aus Diodenkopfdrähten 39 der Plusdioden 25 und die Verbindungsdrähte 48, die zur Verbindung mit den Diodenkopfdrähten 39 der Plusdioden 25 dienen, isoliert sind. Weitere Verbindungsdrähte 48 der Verschaltungsplatte 40 ragen durch Öffnungen 50 im Pluskühlkörper 35 hindurch. Diese Gleichrichterteilbaugruppe wird so beschichtet, dass die durch die Öffnungen 50 hindurchragenden Teile der Verschaltungsplatte 40 nicht durch den Isolationsstoff beschichtet sind. Diese Verbindungsdrähte 48 sind dazu vorgesehen, mit den Diodenkopfdrähten 39 der Minusdioden 24 verbunden zu werden. Wären diese Verbindungsdrähte 48 vor dem Verbinden beschichtet, müsste diese Schicht extra entfernt werden.

Die Beschichtung für die Gleichrichterteilbaugruppe aus Figur 9 kann unterschiedlich ausgeführt werden. Besprüht man die der Verschaltungsplatte 40 zugewandte Seite des Pluskühlkörpers 35, so werden sowohl die Verschaltungsplatte 40, als auch die Unterseite des Pluskühlkörpers 35 sowie sämtliche dazwischen liegenden Verbindungsdrähte beschichtet. Dieses Ergebnis kann beispielsweise auch durch Eintauchen dieser Gleichrichterteilbaugruppe erreicht werden, wobei die Tauchrichtung der Richtung der Diodenkopfdrähte 39 entspricht. Ist jedoch erwünscht, nur die Verschaltungsplatte 40 zu isolieren, so ist ein Eintauchen dieser Gleichrichterteilbaugruppe nur auf diese Verschaltungsplatte 40 zu beschränken. Soll nur die Verschaltungsplatte 40 besprüht werden, so ist die der Verschaltungsplatte 40 zugewandte Unterseite des Pluskühlkörpers 35 mittels geeigneter Masken abzudecken. Nach dem Eintauchen bzw. Besprühen der Gleichrichterteilbaugruppe wird diese mit dem Minuskühlkörper 37 verbunden. Der Minuskühlkörper 37 ist beispielsweise wiederum als Lagerschild 60 ausgebildet.

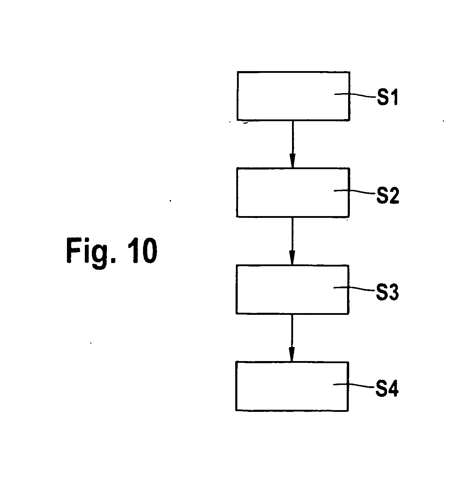

Figur 10 zeigt einige Verfahrensschritte. In einem ersten Verfahrensschritt S1 wird ein Kühlkörper bereitgestellt und in dessen Öffnungen bzw. an geeigneten Positionen die entsprechenden Dioden befestigt, S1. In einem zweiten Verfahrensschritt S2 wird die Verschaltungsplatte 40 mit den Diodenkopfdrähten 39 der bereits befestigten Dioden verbunden. In einem nachgelagerten dritten Verfahrensschritt S3 wird die Gleichrichterteilbaugruppe mittels Tauchen oder Sprühen im entsprechenden gewünschten Umfang beschichtet. Im vierten Verfahrensschritt S4 wird die Gleichrichterteilbaugruppe mit dem gegenpoligen Kühlkörper und dessen Dioden verbunden.

Aus den Ausführungsbeispielen gemäß Figur 9 und Figur 10 ist somit ein Verfahren zum Herstellen einer Gleichrichterbaueinrichtung 20 offenbart, wonach an einem im Wesentlichen ebenen Kühlkörper diesen zugeordnete Dioden befestigt und Anschlussleiter der Dioden mit Verschaltungsleitern verbunden werden und somit eine Gleichrichterteilbaugruppe gebildet ist, wobei die Gleichrichterteilbaugruppe so beschichtet wird, dass die Anschlussleiter und die Verbindungsleiter isoliert sind. Gemäß einer weiteren Ausbildung des Verfahrens ist vorgesehen, dass die Gleichrichterteilbaugruppe so beschichtet wird, dass die Verschaltungsleiter, die Anschlussleiter und eine diesen zugewandte Seite eines Kühlkörpers isoliert sind.

## Patentansprüche

1. Gleichrichterbaueinrichtung für einen Drehstromgenerator, mit einem ersten elektrischen Leiter zum Führen eines ersten Spannungspotentials und einem zweiten elektrischen Leiter zum Führen eines zweiten, niedrigeren Spannungspotentials, wobei der erste Leiter und der zweite Leiter benachbart sind,
wobei der erste Leiter als Diodenkopfdraht (39) ausgebildet ist und mit einer negativen Seite (28) einer Plusdiode (25) verbunden ist, die in der Öffnung eines Pluskühlkörpers (35) steckt,
wobei der zweite Leiter mit einer negativen Seite (28) einer Minusdiode (24) verbunden und als Minuskühlkörper (37) ausgebildet ist, in dessen Öffnung die Minusdiode (24) steckt
und dass die Diodenkopfdrähte (39) jeweils zweier Dioden einer Gleichrichterbrücke (23) mittels einer Verschaltungsplatte (40) elektrisch leitend verbunden sind,
**dadurch gekennzeichnet, dass**
nur einer der beiden Leiter lokal an einer Stelle mit einer Isolation (45) beschichtet ist, wobei die Stelle dem anderen Leiter gegenübersteht.

2. Gleichrichterbaueinrichtung nach Anspruch 1, wobei der als Minuskühlkörper (37) ausgebildete zweite Leiter derjenige Leiter ist, welcher lokal an einer Stelle mit einer Isolation (45) beschichtet ist und zusätzlich eine lokale Isolationsschicht (45) auf der Seite des Pluskühlkörpers (35) vorgesehen ist, die dem Diodenkopfdraht (39) einer Minusdiode (24) gegenüber angeordnet ist.

3. Gleichrichterbaueinrichtung nach Anspruch 2, **dadurch gekennzeichnet, dass** die zusätzliche Isolationsschicht (45) auf der Seite des Pluskühlkörpers (35) lokal beschichtet ist.

4. Gleichrichterbaueinrichtung nach Anspruch 2, **dadurch gekennzeichnet, dass** die Diodenkopfdrähte (39) jeweils zweier Dioden einer Gleichrichterbrücke (23) mittels einer Verschaltungsplatte (40) elektrisch leitend verbunden sind.

5. Verfahren zum Herstellen einer Gleichrichterbaueinrichtung für einen Drehstromgenerator, wonach in einem ersten Verfahrensschritt ein Pluskühlkörper (35) und ein Minuskühlkörper (37) bereitgestellt werden und Plusdioden (25) und Minusdioden (24) in Öffnungen des Pluskühlkörpers (35) bzw. des Minuskühlkörpers (37) so befestigt werden, dass ein erster Leiter als Diodenkopfdraht (39) ausgebildet wird, welcher mit einer negativen Seite (28) einer Plusdiode (25) verbunden ist, die in der Öffnung eines Pluskühlkörpers (35) steckt
und ein zweiter Leiter als Minuskühlkörper (37) ausgebildet wird, welcher mit einer negativen Seite (28) einer Minusdiode (24) verbunden ist, die in der Öffnung des Minuskühlkörpers (37) steckt
und in einem zweiten Verfahrensschritt eine Verschaltungsplatte (40) mit den Diodenkopfdrähten (39) der bereits befestigten Dioden elektrisch verbunden wird,
und in einem nachgelagerten dritten Verfahrensschritt die Gleichrichterteilbaugruppe so beschichtet wird, dass nur einer der beiden Leiter lokal an einer Stelle mit einer Isolation (45) beschichtet ist, wobei die Stelle dem anderen Leiter gegenübersteht.

## Claims

1. Rectifier device for a polyphase generator, having a first electrical conductor for carrying a first voltage potential and having a second electrical conductor for carrying a second, lower voltage potential, wherein the first conductor and the second conductor are adjacent,
wherein the first conductor is in the form of a diode head wire (39) and is connected to a negative side (28) of a positive diode (25) which is inserted in the opening in a positive heat sink (35),
wherein the second conductor is connected to a negative side (28) of a negative diode (24) and is in the form of a negative heat sink (37), in whose opening the negative diode (24) is inserted,
and in that the diode head wires (39) of in each case two diodes of a rectifier bridge (23) are electrically conductively connected by means of a circuit board (40),
**characterized in that**
only one of the two conductors is locally coated with insulation (45) at a point, with the point being opposite the other conductor.

2. Rectifier device according to Claim 1, wherein the second conductor, which is in the form of a negative heat sink (37), is that conductor which is locally coated with insulation (45) at one point and, in addition, a local insulation layer (45) is provided on that side of the positive heat sink (35) which is arranged opposite the diode head wire (39) of a negative diode (24).

3. Rectifier device according to Claim 2,
**characterized in that** the additional insulation layer (45) is locally coated on the side of the positive heat sink (35).

4. Rectifier device according to Claim 2,
**characterized in that** the diode head wires (39) of in each case two diodes of a rectifier bridge (23) are electrically conductively connected by means of a circuit board (40).

5. Method for producing a rectifier device for a polyphase generator, according to which, in a first method step, a positive heat sink (35) and a negative heat sink (37) are provided, and positive diodes (25) and negative diodes (24) are mounted in openings in the positive heat sink (35) and in the negative heat sink (37), respectively, such that a first conductor is in the form of a diode head wire (39) which is connected to a negative side (28) of a positive diode (25) which is inserted in the opening in a positive heat sink (35),
and a second conductor is in the form of a negative heat sink (37), which is connected to a negative side (28) of a negative diode (24) which is inserted in the opening in the negative heat sink (37),
and, in a second method step, a circuit board (40) is electrically connected to the diode head wires (39) of the already mounted diodes,
and, in a subsequent third method step, the rectifier subassembly is coated such that only one of the two conductors is locally coated with insulation (45) at one point, with the point being opposite the other conductor.

## Revendications

1. Module redresseur pour générateur de courants tournants, qui présente un premier conducteur électrique qui amène un premier potentiel de tension et un deuxième conducteur électrique qui amène un deuxième potentiel de tension, plus bas, le premier conducteur et le deuxième conducteur étant voisins,
le premier conducteur étant configuré comme fil (39) de tête de diode et étant relié à un côté négatif (28) d'une diode plus (25) qui est enfichée dans l'ouverture d'un corps (35) de refroidissement plus,
le deuxième conducteur étant relié à un côté négatif (28) d'une diode moins (24) et étant configuré comme corps (37) de refroidissement moins dans l'ouverture duquel la diode moins (24) est enfichée,
les fils (39) de tête de diode étant reliés de manière électriquement conductrice à deux diodes d'un pont redresseur (23) au moyen d'une carte de circuit (40),
**caractérisé en ce que**
un seul des deux conducteurs est revêtu localement d'une isolation (45) en un emplacement situé face à l'autre conducteur.

2. Module redresseur selon la revendication 1, dans lequel le deuxième conducteur configuré comme corps (37) de refroidissement moins est le conducteur qui est revêtu localement d'une isolation (45) en un emplacement, une couche locale supplémentaire d'isolation (45) étant prévue sur le côté du corps de refroidissement (35) plus qui est situé face au fil (39) de tête d'une diode moins (24).

3. Module redresseur selon la revendication 2, **caractérisé en ce que** la couche d'isolation supplémentaire (45) est appliquée localement sur le côté du corps (35) de refroidissement plus.

4. Module redresseur selon la revendication 2, **caractérisé en ce que** les fils (39) de tête de diode sont reliés de manière électriquement conductrice à deux diodes d'un pont redresseur (23) au moyen d'une carte de circuit (40).

5. Procédé de fabrication d'un module redresseur pour générateur de courants tournants, dans lequel, dans une première étape du procédé:
un corps de refroidissement (35) plus et un corps de refroidissement (37) moins sont préparés,
des diodes plus (25) et des diodes moins (24) sont fixées dans des ouvertures respectives du corps (35) de refroidissement plus et du corps (37) de refroidissement moins,
un premier conducteur est configuré comme fil (39) de tête de diode relié au côté négatif (28) d'une diode plus (25) qui est enfichée dans l'ouverture d'un corps (35) de refroidissement plus,
un deuxième conducteur est configuré comme corps (37) de refroidissement moins relié au côté négatif (28) d'une diode moins (24) qui est enfichée dans l'ouverture du corps (37) de refroidissement moins, et dans lequel, dans une deuxième étape du procédé:
une carte de circuit (40) est reliée électriquement aux fils (39) de tête de diode des diodes déjà fixées,
tandis que dans une troisième étape de traitement ultérieur, les parties du module redresseur sont revêtues en revêtant un seul des deux conducteurs localement par une isolation (45) en un emplacement situé face à l'autre conducteur.
